# EUROPEAN PATENT SPECIFICATION

(11) **EP 4 350 978 B1**
(45) Date of publication and mention of the grant of the patent: **30.09.2026**
(21) Application number: 22306508.7
(22) Date of filing: 07.10.2022
(51) Int. Cl.: H02P 29/024, G01R 31/34

(54) **METHOD FOR DETECTING A MOTOR FAULT DURING TRANSIENT OPERATION AND DEVICE THEREFOR**
VERFAHREN ZUR ERKENNUNG EINES MOTORFEHLERS WÄHREND EINES TRANSIENTEN BETRIEBS UND ENTSPRECHENDE VORRICHTUNG
PROCÉDÉ DE DÉTECTION D'UN DÉFAUT DE MOTEUR PENDANT UN FONCTIONNEMENT TRANSITOIRE ET DISPOSITIF ASSOCIÉ

(43) Date of publication of application: 10.04.2024
(73) Proprietor: Mitsubishi Electric R & D Centre Europe B.V., 1119 NS Schiphol Rijk (NL); MITSUBISHI ELECTRIC CORPORATION, Chiyoda-ku Tokyo 100-8310 (JP)
(72) Inventor: VOYER, Nicolas, 35708 RENNES Cedex (FR); BARLINI, Davide, 35708 RENNES Cedex 7 (FR)
(74) Representative: Cabinet Le Guen Maillet

(56) References cited:
- EP-A2- 0 698 795
- US-A- 5 689 194
- AMIRAT YASSINE ET AL: "Variational Mode Decomposition-based Notch Filter for Bearing Fault Detection", IECON 2019 - 45TH ANNUAL CONFERENCE OF THE IEEE INDUSTRIAL ELECTRONICS SOCIETY, IEEE, vol. 1, 14 October 2019 (2019-10-14), pages 6028 - 6033, XP033669738, [retrieved on 20191206], DOI: 10.1109/IECON.2019.8926891

## Description

### TECHNICAL FIELD

The present invention relates generally to a method for detecting a motor fault during transient operation.

### RELATED ART

Several motor faults may occur in rotating machines, e.g., when stator and rotor rotation axis are misaligned, when bearings are damaged, when rotor bars in stator get broken, or under damaged winding isolation, etc. Such faults cause wear of motor bearings, unexpected oscillations in produced torque and undesired vibrations which can harm the plant.

In state of art, motor faults can be detected using vibration sensors or current sensors, or a combination of both. Each motor fault has a specific frequency signature, which can be detected from the measured current waveform. MCSA (Motor Current Signal Analysis) technique is popular as it reuses the current sensors required for closed-loop control of the motor. The level and the frequency of fault harmonic vary with rotational speed, applied torque, and type and level of fault.

In asynchronous machines, the rotor frequency differs from the stator frequency, the difference (rotor slip) is caused by the application of torque. Many applications are not equipped with position sensor, so that it is difficult to estimate the rotor frequency and/or the rotor slip.

Popular MCSA methods estimate presence of motor faults using time-frequency transforms, (e.g. Fourier, Wavelet...) of the input (e.g. phase current) waveform. Fourier method decomposes the input waveform in a base of equally spaced gyrators. SFFT or STFT method can follow the evolution of gyrator components over time in both steady-state and transient applications.

Prior Art is subject to numerous problems. FFT methods require the acquisition, storage and treatment of waveforms with long duration (e.g. 10s for 0.1Hz accuracy). The processing is then hardly compatible with implementation of motor controller.

The measured waveform comprises a strong component at stator frequency. This fundamental signal is superposed to fault signature signal and several orders of magnitude bigger than the fault signature signal.

The fault frequency varies with rotor frequency, that is generally unknown due to rotor slip. Estimating the frequency of the fault signature signal is possible using FLL (frequency lock loop), but FLL is more likely to lock on strong fundamental signal rather than on the fault signature signal, and FLL is prone to locking errors, especially for noisy signals. The machine may also experience more than one fault type.

Such techniques do not enable the detection of motor fault during transient operation of the machine. In many applications, the operation conditions (speed and torque) are not static and cannot be maintained over large period.

The paper of AMIRAT YASSINE ET AL: "Variational Mode Decomposition-based Notch Filter for Bearing Fault Detection", IECON 2019 - 45TH ANNUAL CONFERENCE OF THE IEEE INDUSTRIAL ELECTRONICS SOCIETY, IEEE, vol. 1, 14 October 2019 (2019-10-14), pages 6028-6033, discloses the use of notch filter to extract a dominant mode and an heterodyne demodulation.

The patent application EP 0698795 A2 discloses a method and apparatus for determining mechanical performance of polyphase electrical motor system.

### SUMMARY OF THE INVENTION

The present invention aims to provide a method for detecting a motor fault during transient operation of the motor wherein the method comprises the steps of:
- sensing a motor signal,
- identifying a fundamental frequency of the motor signal, the fundamental frequency being the frequency of the voltage waveforms driving the stator of the motor,
- performing a heterodyne incoherent demodulation of the motor signal on a frequency band, the central frequency of the frequency band and the bandwidth of the frequency band having fixed proportionality ratio with the identified fundamental frequency,
- determining the level of fault in the motor by comparing the demodulated signal and a signal derived from the motor signal.

The present invention concerns also a device for detecting a motor fault during transient operation of the motor wherein the device comprises:
- means for sensing a motor signal,
- means for identifying a fundamental frequency of the motor signal, the fundamental frequency being the frequency of the voltage waveforms driving the stator of the motor,
- means for performing a heterodyne incoherent demodulation of the motor signal on a frequency band, the central frequency of the frequency band and the bandwidth of the frequency band having fixed proportionality ratio with the identified fundamental frequency,
- means for determining the level of fault in the motor by comparing the demodulated signal and a signal derived from the motor signal.

Thus, the level of fault can be estimated, as long as the fault signature signal has a frequency contained in the frequency band. The level of fault (such as level of eccentricity for eccentricity fault) can be determined from the level of detected fault signature signal. The level of fault signature signal is estimated even when the exact frequency of fault signature signal is not perfectly known, as example due to the presence of slip between stator and rotor frequencies in induction machines.

The level of fault signature signal can get estimated without implementation of complex time-frequency signal analysis, such as SFFT. Detection of motor fault can be realised with low complexity and can be implemented in General Purpose Inverter without additional sensor and/or computing capacity.

The level of fault is estimated on-the-fly across consecutive signal inputs. The method does not need to store data on large analysis window. The level of fault is estimated in short time and is robust to rapid changes of operation conditions of the machine (torque and speed).

As the frequency of motor faults is always determined as a weighted sum of stator and rotor frequencies, the processing is simple and effective for all rotor speeds. The bandwidth to stator frequency ratio can be chosen so that modifications of the rotor frequency due to slip always keeps the fault signature signal within the selected frequency band. As the selected frequency band is indexed to the stator frequency, the method can track level of fault during transient speed conditions.

The method is effective in applications that rarely or never meet long steady-state conditions.

According to a particular feature, the incoherent demodulation comprises the steps of:
- mixing the motor signal with a sine and a cosine waveforms oscillating at the central frequency,
- low-pass filtering the mixed signals with a cutoff frequency equal to the bandwidth of the frequency band,
- combining the low-pass filtered signals.

Thus, the fault signature signal can be demodulated with another reference signal positioned at the central frequency, as long as its frequency belongs to the frequency band, i.e. as long as the frequency of the fault signature signal has a distance to the central frequency smaller than the cut-off frequency. The precise frequency of the signature fault signal needs not to be estimated. The method needs no systematic search across all frequencies such as in time-frequency analysis method. It does not either requires the estimation of rotational frequency, reducing the risks and costs associated with estimation or sensing of rotor position.

The level of fault signature signal is estimated without loss or undesired oscillation of energy, as energy is collected both on in-phase and quadrature components of the reference signal.

Interfering signals, such as second-order harmonic resulting from the mixers, are suppressed as long as their frequency is located away from the frequency band. Fixed ratios can be set tightly so as to reject all undesired harmonic that may otherwise jam the estimation of fault. It is possible to discriminate faults of different type, as they are located in different segments of the spectrum.

According to a particular feature, the method further comprises the step executed prior to the incoherent demodulation of:
- notch filtering the motor signal, the central frequency of the notch filter being equal to the identified fundamental frequency, the width of the notch filter having fixed proportionality ratio with the fundamental frequency, the central frequency of the frequency band being outside of the notch filter band.

Thus, the demodulation in the frequency band is robust to the detection of tiny fault signature signal when the frequency band is next to a strong current signal, such current flowing at fundamental frequency of the motor. The cross-channel interference is minimised and the method can detect tiny fault levels. The method is suited for condition monitoring of motor, where the condition of the machine is regularly monitored from initial zero-fault conditions up to severe fault conditions, before which predictive maintenance can be planned to fix the fault, without risking to abruptly stop the application in presence of accident caused by severed faults.

According to a particular feature, the proportionality ratios of the central frequency of the frequency band, the bandwidth of the frequency band, and the central frequency of the notch filter with the fundamental frequency are predetermined for a given fault type.

Thus, several fault types can be monitored at once, by simple replication of the method, using different set of proportionality ratios. Fault signature exhibits harmonics at positions that combine integer numbers of stator and of rotor frequencies. While rotor frequency is generally unknown, it only differs from the stator frequency by the frequency slip, which can be upper bounded. Indeed, maximum slip relates to the maximum torque of the motor. As a result, the frequency range where fault harmonic is located can be determined tightly.

According to a particular feature, the method further comprises the step executed prior to the heterodyne incoherent demodulation and/or the notch filtering of :
- angular resampling the motor signal, the resampled signal having equal-phase increment of signal rotating at the identified fundamental frequency.

Thus, the number of signal samples to be processed is reduced, and the numerical complexity of the method is reduced. Because the central frequency and the bandwidth of the frequency band have fixed proportionality ratio with fundamental frequency, and because the signal is resampled with equal phase increment of signal rotating at the fundamental frequency, the following processing for detecting motor fault becomes independent of the fundamental frequency and is therefore robust to changes in stator frequency. The method is thus suited for tracking the fault level during transient conditions.

According to a particular feature, the notch filtering and the low-pass filtering are implemented as IIR filters with fixed predetermined coefficients.

Thus, the implementation of the notch and low-pass filters has very low complexity. IIR filtering requires minimal storage of past motor signal samples (typically up to 4 samples only, much less compared to SFFT method that requires several thousand samples).

Because the motor signal was resampled with equal phase increment, and because the bandwidth and cut-off frequencies of the filters are proportional to the speed level, the implementation of IIR filter is realised with constant internal coefficients, even when fundamental frequency evolves such as during transient conditions, e.g. speed ramps.

The coefficients of the notch and low-pass filters need not be adapted to evolving speed conditions. Abrupt change of IIR coefficients can otherwise result in instabilities in the outputs produced by the filters, conflicting with the objective to track fault condition with good accuracy also in fast changing operating conditions. In contrast, the method implementing IIR with fixed coefficients is optimised to track levels of motor fault signatures during speed transients. According to a particular feature, the signal derived from the motor signal is obtained by:
- performing an envelope detection on the sensed motor signal,
- determining a proportionality ratio between fault harmonic level and a level of fault in the motor from the envelope and the fundamental frequency,
- performing an angular resampling of the proportionality ratio,
- notch filtering the resampled proportionality ratio,
- low pass filtering the notch filtered resampled proportionality ratio.

Thus, the level of fault is determined from the demodulated level of fault signature signal. The evolving level of fault can indicate to the application user how to set the time to trigger preventive maintenance so as to fix the level of fault. As example, eccentricity fault may gradually grow, reducing the minimal distance between rotor and stator. Technician can be sent on site to fix the eccentricity before the eccentricity gets too high, with potential risk of rotor hitting the stator, with possibly catastrophic consequences on the mechatronic chain.

As proportionality ratio passes through the rigorously same signal processing chain (notch + LPF filters), it experiences the same delay from the processing chain, and the final result gets more robust to changes in signal envelope (torque) or fundamental frequency. The estimation of fault level is robust to fast transient conditions.

The proportionality ratio compensates for variations of fault harmonic with level of torque and of speed.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents a first example of a device for detecting a motor fault during transient operation according to the invention;
Fig. 2 represents an example of a block diagram of a heterodyne demodulation module used in the present invention;
Fig. 3 represents an example of a block diagram of an Infinite Impulse Response filter that is used according to the present invention;
Fig. 4 represents an example of a block diagram of a phase module of the device for detecting a motor fault in transient operation according to the present invention;
Fig. 5 represents a second example of a device for detecting a motor fault during transient operation according to the invention;
Fig. 6 represents an example of an algorithm for detecting a motor fault during transient operation according to the invention.
Fig. 7a and 7b represent first and second examples of spectral treatment of motor signal in presence of motor fault according to the invention.

### DESCRIPTION

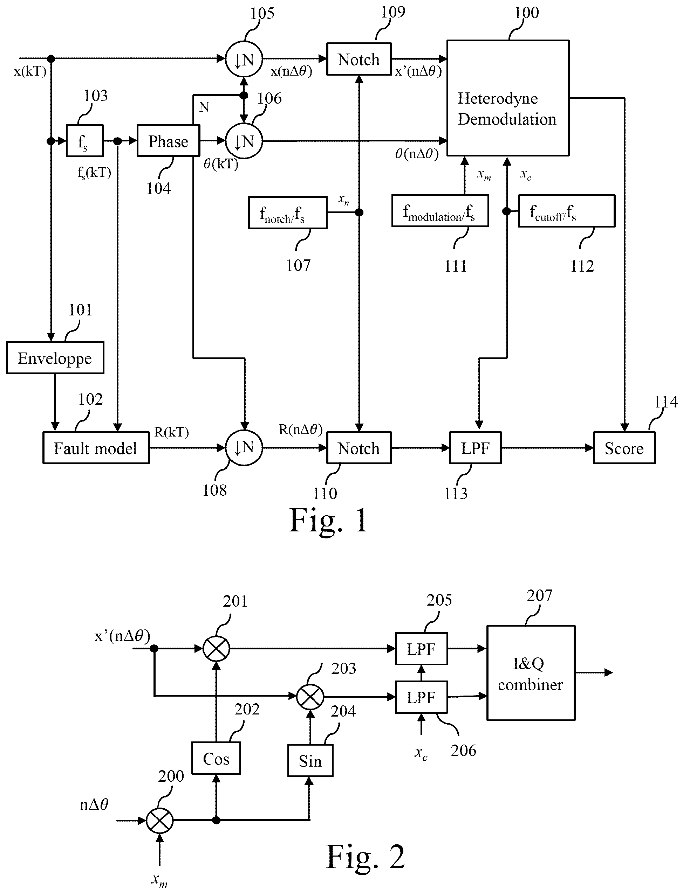

Fig. 1 represents a first example of a device for detecting a motor fault during transient operation according to the invention.

The device for detecting a motor fault during transient operation comprises means 103 for identifying a fundamental frequency *fs* of a motor signal, the fundamental frequency being the frequency of the voltage waveforms driving the stator of the motor, means for performing a heterodyne incoherent demodulation of the motor signal on a frequency band, the central frequency of the frequency band and the bandwidth of the frequency band being proportional to the identified fundamental frequency and means for determining the level of fault in the motor by comparing the demodulated signal and a signal derived from the motor signal.

The motor signal is as example the current waveform flowing in one stator winding of the motor. In another example, the device comprises an inverter and a controller, and the motor signal is the reference voltage determined by the controller and used for controlling the inverter that feeds the motor with electric power. In yet another example, the device comprises a vibration sensor, and the motor signal is the sensed vibration signal sensed by the vibration sensor.

The device for detecting a motor fault during transient operation may further comprise angular resampling of the motor signal and infinite impulse response filters. The device for detecting a motor fault during transient operation may further comprise notch filters.

The device for detecting a motor fault during transient operation may further comprise a scoring function, which scales the level of fault harmonic detected by incoherent heterodyne demodulation to the level of fault of the motor with a ratio adapted to the transient speed and current conditions experienced by the motor.

The scoring function comprises an envelope detection module 101 that determines the norm ∥*x*∥(*kT*) of the motor signal *x(kT).* The norm ∥*x*∥(*kT*) is provided to a fault harmonic model module 102 that determines a proportionality ratio R(kT) between fault harmonic level and the level of fault in the motor.

The scoring function may further comprise angular resampling of the motor signal 108, a notch filter 110 and an infinite impulse response filter 113.

A fundamental detection module 103 determines an angular frequency *fₛ(kT)* of the motor signal *x(kT).*

The angular frequency *fₛ(kT)* is provided to the fault harmonic model module 102 and to a phase determination module 104.

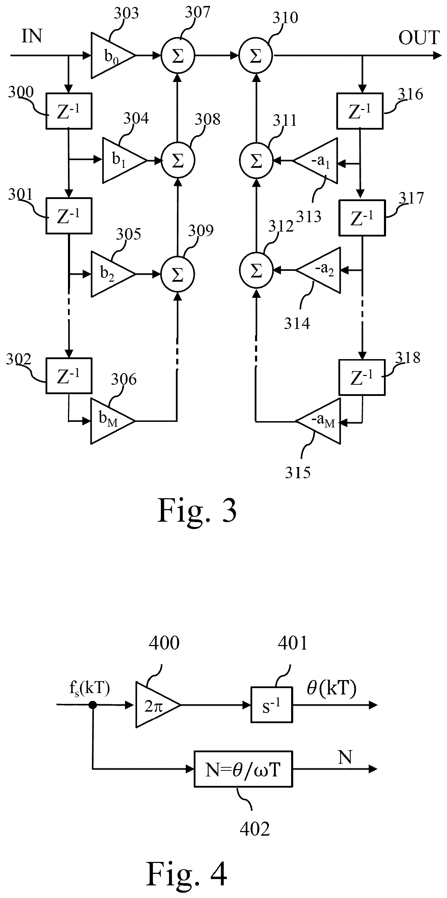

The phase determination module 104 is disclosed in more detail in reference to Fig. 4.

In a first implementation of the invention, the phase determination module 104 provides a down-sampling ratio N to angular resampling modules 105, 106 and 108 and a phase signal *θ(kT)* to the angular resampling module 106.

In a second implementation of the invention, the phase determination module 104 provides a phase signal *θ(kT)* to angular resampling modules 105, 106 and 108.

The concept of angular resampling consists in producing a set of samples with equi-phase distance from samples with equi-time distance. Together with fixed proportions between fundamental frequency, filter bandwidth and filter cut-off frequency, angular resampling enables the implementation of notch and LPF filters as IIR filters with constant coefficients, even under varying fundamental frequencies, e.g. in presence of speed ramps.

In the first implementation of the invention, angular resampling consists in down sampling the input signal with a ratio N that is inversely proportional to the fundamental frequency. $N = \frac{Δ θ}{2 {πf}_{s} \left(t\right) Δ T}$

In the second implementation of the invention, angular resampling consists in selecting samples of input signal corresponding to times at which the determined phase angle crosses a ladder of levels spaced by Δ*θ*.

As example, Δ*θ* is chosen to be representative of a value between 1° and 20°.

The angular resampling module 105 provides angular samples *x(nΔθ)* to a notch filter 109.

The filtered angular samples *x'(nΔθ)* are provided to the heterodyne incoherent demodulation module 100.

The angular resampling module 106 provides angular samples *nΔθ* to the heterodyne incoherent demodulation module 100.

The heterodyne incoherent demodulation module 100 is described in more details in reference to Fig. 2.

The angular resampling module 108 provides angular samples *R(nθΔ)* to a notch filter 110.

The output of the notch filter 110 is provided to the low pass filtering module 113.

The device for detecting a motor fault during transient operation of the motor comprises a normalised notch ratio determination module 107 that provides a ratio *xₙ* between the bandwidth of notch filter and the fundamental frequency to the notch filters 109 and 110.

The device for detecting a motor fault during transient operation comprises a low pass filter frequency determination module 112 that provides a ratio *x_{c}* between the cut-off frequency of low pass filter and the fundamental frequency to the low pass filter 113 and to the heterodyne incoherent demodulation module 100.

The device for detecting a motor fault during transient operation comprises a demodulation frequency determination module 111 that provides a ratio *xₘ* between the demodulation frequency and the fundamental frequency to the heterodyne incoherent demodulation module 100.

The triplet of ratios (*xₙ, x_{c}*, *xₘ*) is chosen so that the desired fault harmonic is located in a search window f_{fault}/f_{fundamental} [xₘ-x_{c}/2 ; xₘ+x_{c}/2] . As example, the fault is an eccentricity fault and xₘ = 0.5, x_{c} = 0.1 enables the detection of eccentricity fault as long as frequency slip is lower than 10%, as the related lower sideband (fs-fr) fault frequency is located within a window f_{fault}/f_{fundamental} [0.4 0.6]. The demodulation is effective for any frequency slip, as the harmonic (fs-fr) is always located in the chosen demodulation band. The method is thus robust to changes of rotational speed fr resulting from change in torque applied to the motor by the load.

As another example, xₘ = 1.5, x_{c} = 0.1 enables the detection of eccentricity fault as long as frequency slip is lower than 10%, as the related upper sideband (fs+fr) fault frequency is located within a window f_{fault}/f_{fundamental} [1.4 1.6].

As yet another example, xₘ = 3.5, x_{c} = 0.1 enables the detection of the upper sideband fault harmonic around the 3rd fundamental harmonic. More generally, the triplet of ratios can be predetermined for any frequency signature associated to each type of motor fault, and the method is equally applicable to the detection of any fault.

The device for detecting a motor fault during transient operation comprises a score determination module 114 that determines an estimated level of motor fault by comparing the demodulated signal from heterodyne incoherent demodulation module 110 and a signal derived from the signal provided by the motor from the output of the low pass filter 113.

The level of fault harmonic varies with speed and current. A model can relate the level of fault harmonic H_{fault_est} to the level of speed fs and of current I. As example, the estimated level of motor fault is given by a formulation H_{fault_est} = A*Fault*fs^B*I^C, where A, B and C are constant values.

As other example, H_{fault_est} = A*Fault(1+B*fs), where A, B are constant values.

In presence of fast speed ramps, the demodulated signal H_{fault} comes with some delay compared to the instant speed and current, due to the delays induced by Notch and IIR filters.

According to invention, the model ratio K=H_{fault_est}/Fault is passed through a signal processing chain which mimics the delays induced by the signal processing chain. This includes an angular resampling 108, notch and LPF filters 110 and 113. The resulting ratio is then used to divide the output H_{fault} of the heterodyne demodulation so as to produce a fault estimator Fault_est = H_{fault}/K.

**Fig. 2** represents an example of a block diagram of a heterodyne demodulation module used in the present invention.

The incoherent heterodyne demodulation module 100 comprises three multiplication modules 200, 201 204, a cosine determination module 202, a sine termination module 204, two low pass filters 205 and 206 and an I&Q combiner 207.

The multiplication module 200 multiplies the modulation frequency ratio *xₘ* to the angular samples *nθΔ*. The result of the multiplication module 200 is provided to the cosine determination module 202, the output of which is provided to the multiplication module 201. The result of the multiplication module 200 is further provided to the sine determination module 204, the output of which is provided to the multiplication module 203.

The multiplication module 201 is an in-phase mixer, which multiplies the filtered angular samples *x'(nθΔ)* to the output of the cosine determination module 202.

The output of the multiplication module 201 is provided to the lowpass filter 205.

The multiplication module 203 is a quadrature mixer, which multiplies the filtered angular samples *x'(nθΔ)* to the output of the sine determination module 204.

The output of the multiplication module 203 is provided to the lowpass filter 206.

The low pass filters 205 and 206 are preferably Infinite Impulse Response filters with a cut off frequency *x_{c}.*

The output of the low pass filters 205 and 206 represent in-phase and quadrature demodulation results of signals present within the band (xₘ+/-x_{c}/2)*fs. These outputs are provided to the I&Q combiner 207. I&Q combiner 207 outputs the square root value of the sum of square values of in-phase and quadrature channels.

The output of the I&Q combiner 207 is provided to the score module 114.

The ratios xₛ, xₘ, x_{c} between Notch filter bandwidth fn, mixer frequency *fm,* LPF frequency *fc* and the stator frequency *fs* are constant and for a machine with 2 pole pairs, is as example given by:${x}_{m} = 0.5$ *x_{c}=*1/12 and *xₙ=*1/12

Other ratios are possible and can be selected to detect frequency components of various fault modes, such as static/dynamic eccentricity faults, broken rotor bar, etc which signature signal is located in the band defined by [fm-fc, fm+fc] = fs*[xₘ-x_{c}, xₘ+x_{c}].

The level of fault signature is typically small compared with the fundamental signal. The Notch filter first reduces all components in a band *fn* around the stator frequency. The mixers move all frequency components to the left, so that the corresponding frequency component *fm* be located at DC. The LPF reduces all signals away from the demodulation bandwidth fc, so that remaining fundamental signal and higher-order harmonic vanish. I&Q combiner sums the energies of in-phase and quadrature channels to get rid of phase uncertainty of unknown signal located in the desired band. I&Q combiner estimates the level of Single-tone harmonic signal which frequency is contained in the frequency band [fm-fc, fm+fc].

**Fig. 3** represents an example of a block diagram of an Infinite Impulse Response filter that is used according to the present invention.

IIR filter is implemented using a set of delay lines 300, 301, 302, 316, 317, 318, amplifiers 303, 304, 305, 306, 313, 314, 315, and summators (307, 308, 309, 310, 311, 312). Its complexity is very small so it can easily be implemented in either software or hardware. It can filter input signals in real-time with minimal storage of past signal events. Filter coefficients bₖ apply to the input, while coefficients aₖ apply to the output.

The filter coefficients are determined to reach a desired spectral response. IIR Filters can be determined from analogue filter transfer function as example through bilinear approximation, or impulse invariant transform.

For a first-order notch filter, the desired response function is $N \left(s\right) = \frac{{s}^{2} + {{ω}_{s}}^{2}}{{s}^{2} + {ω}_{n} s + {{ω}_{s}}^{2}}$ and the coefficients are given by bilinear transformation, where ${a}_{1} = \frac{2 \left(1-{K}^{2}\right)}{1 + αK + {K}^{2}} ;$ ${a}_{2} = \frac{1 - αK + {K}^{2}}{1 + αK + {K}^{2}} ;$ ${b}_{0} = {b}_{2} = \frac{1 + {K}^{2}}{1 + αK + {K}^{2}} ;$ ${b}_{1} = {a}_{1}$ where *K =* 2*Fₛ*/*ωₛ*, *α* = *ωₙ*/*ωₛ*

As *Fₛ*/*ωₛ* is constant thanks to resampling, and as *ωₙ*/*ωₛ* was selected to be constant, the filter coefficients need not be recomputed if speed varies.

For a 3^{rd} order Butterworth LPF filter, the desired response function is $BW \left(s\right) = \frac{1}{\left(1+s/{ω}_{c}\right) \left(1+s/{ω}_{c}+{\left(s/{ω}_{c}\right)}^{2}\right)}$ and the coefficients are given by bilinear transformation as ${b}_{0} = \frac{1}{1 + 2 K + 2 {K}^{2} + {K}^{3}} = {b}_{3} ;$ ${b}_{1} = {b}_{2} = 3 {b}_{0} ;$ ${a}_{1} = \frac{3 + 2 K - 2 {K}^{2} - 3 {K}^{3}}{1 + 2 K + 2 {K}^{2} + {K}^{3}} ;$ ${a}_{2} = \frac{3 - 2 K - 2 {K}^{2} + 3 {K}^{3}}{1 + 2 K + 2 {K}^{2} + {K}^{3}} ;$ ${a}_{3} = \frac{1 - 2 K + 2 {K}^{2} - {K}^{3}}{1 + 2 K + 2 {K}^{2} + {K}^{3}} ;$ where *K* = *2Fₛ*/*ω_{c}*, *Fₛ* being the sampling frequency.

As *Fₛ*/*ωₛ* is constant thanks to resampling, and as *x_{c}* = *ω_{c}*/*ωₛ* was selected to be constant, the filter coefficients need not be recomputed if speed varies.

In a preferred implementation, both *Fₛ* and *ω_{c}* are chosen to be normalised with respect to stator speed, i.e. *Fₛ* = 1/Δ*θ*, *ω_{c} = f_{c}*/*fₛ*. This brings less alteration in case of speed changing very quickly across successive samples inside the IIR filter.

The filters 109, 110, 113, 205 and 206 are Infinite Impulse Response filters.

The IIR filter shown in Fig. 3 is a m-th order filter.

As shown in Fig. 3, the input IN of the IIR filter is provided to a multiplication module 303 that multiplies the input samples by a coefficient b₀ and to an inverse Z transform module 300.

The output of the inverse Z transform module 300 is provided to a multiplication module 304 that multiplies the samples by a coefficient b₁ and to an inverse Z transform module 301.

The output of the inverse Z transform module 301 is provided to a multiplication module 305 that multiplies the samples by a coefficient b₂ and to an m-th inverse Z transform module 302.

The output of the inverse Z transform module 302 is provided to a multiplication module 306 that multiplies the samples by a coefficient b_{M}.

The output of the m-th multiplication module 306 is summed to the output of the multiplication module 305 by the summation module 309.

The output of the summation module 309 is summed to the output of the multiplication module 304 by the summation module 308.

The output of the summation module 308 is summed to the output of the multiplication module 303 by the summation module 307.

The output of the summation module 307 is provided to a summation module 310 that provides filtered output samples OUT.

The output of the summation module 307 is provided to an inverse Z transform module 316.

The output of the inverse Z transform module 316 is provided to a multiplication module 313 that multiplies the samples by a coefficient -a₁ and to an inverse Z transform module 317.

The output of the inverse Z transform module 317 is provided to a multiplication module 314 that multiplies the samples by a coefficient -a₂ and to a m-th inverse Z transform module 318.

The output of the inverse Z transform module 318 is provided to a multiplication module 315 that multiplies the samples by a coefficient -aₘ.

The output of the m-th multiplication module 315 is summed to the output of the multiplication module 314 by the summation module 312.

The output of the summation module 312 is summed to the output of the multiplication module 313 by the summation module 311.

The output of the summation module 311 is summed to the output of the summation module 307 by the summation module 310.

**Fig. 4** represents an example of a block diagram of a phase module of the device for detecting a motor fault in transient operation according to the present invention.

The phase module 104 comprises an amplifier 400, an integrator 401 that derives an angle from the angular frequency *ω(kT)* and a sampling rate determination module 402 that determines the down sampling ratio N as $N = \frac{Δ θ}{2 {πf}_{s} \left(t\right) Δ T}$ from the input frequency *fₛ.*

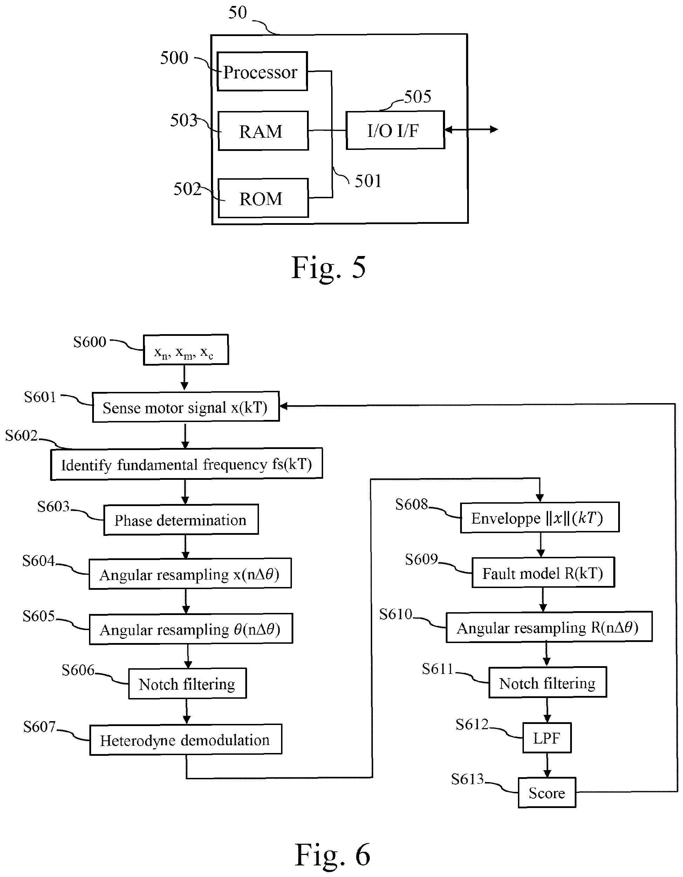

**Fig. 5** represents a second example of a device for detecting a motor fault during transient operation according to the invention.

The device 50 for detecting a motor fault during transient operation of a motor has, for example, an architecture based on components connected by a bus 501 and a processor 500 controlled by a program as disclosed in Fig. 6.

The bus 501 links the processor 500 to a read only memory ROM 502, a random-access memory RAM 503, an input output I/O IF interface 505.

The input output I/O IF interface 505 enables the device 50 to sense motor signal which may contain a spectral signature of a motor fault.

The memory 503 contains registers intended to receive variables and the instructions of the program related to the algorithm as disclosed in Fig. 6.

The read-only memory, or possibly a Flash memory 502, contains instructions of the programs related to the algorithm as disclosed in Fig. 6, that are when the device 50 is powered on, loaded to the random-access memory 503. Alternatively, the program may also be executed directly from the ROM memory 502.

The calculation performed by the device 50 may be implemented in software by execution of a set of instructions or program by a programmable computing machine, such as a PC (*Personal Computer*)*,* a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit).*

In other words, the device 50 includes circuitry, or a device including circuitry, causing the device 50 to perform the program related to the algorithm as disclosed in Fig. 6.

**Fig. 6** represents an example of an algorithm for detecting a motor fault during transient operation according to the invention.

The present algorithm is disclosed in an example wherein it is executed by the processor 500 of the device 50.

At first step S600, the processor 500 identifies the ratios xn,, xm, xc between the bandwidth of notch filter fn, the demodulation frequency fm, the bandwidth fc of demodulation and the fundamental frequency of the motor signal. The ratios are constant for a given fault type. As example, monitoring the upper side band harmonic around first harmonic of eccentricity fault corresponds to (xn,xm,xc)=(1/12, 3/2,1/12). Then processor 500 moves to step S601.

At step S601, the processor 500 senses the motor signal coming from I/O interface 505 and moves to step S602.

At step S602, the processor 500 identifies the fundamental frequency *fs* of the motor signal sensed at step S601. The fundamental frequency is the frequency of the voltage waveforms driving the stator of the motor.

The motor signal is as example the current waveform flowing in one stator winding of the motor. In another example, the motor signal is the reference voltage determined by a controller and used for controlling the inverter that feeds the motor with electric power. The motor signal may be also a sensed vibration signal sensed by a vibration sensor.

At next step S603, the processor 500 determines a phase through integration of the fundamental frequency determined at step S602.

In a first implementation of the invention, the phase determination provides a down-sampling ratio N and a phase signal θ(kT)., $N = \frac{Δ θ}{2 {πf}_{s} \left(t\right) Δ T}$

In a second implementation of the invention, the phase determination provides a phase signal θ(kT).

At step S604, the processor 500 performs an angular resampling of the motor signal x(kT) in order to provide signal samples *x(nΔθ)* with regular angular sampling.

At step S605, the processor 500 performs an angular resampling of the phase signal that provides phase samples *nΔθ* with regular angular sampling.

At step S606, the processor 500 performs a filtering of the resampled signal *x(nΔθ)* provided by the angular resampling step S604. The filtering is a notch filtering as disclosed in reference to Fig. 1.

At step S607, the processor 500 performs a heterodyne incoherent demodulation of the filtered resampled signal x'(nΔθ) provided by the filtering step S606 using the phase samples *nΔθ* and the ratio xₘ and x_{c}. The processor 500 multiplies the phase samples *nΔθ* with ratio xm and computes sine and cosine function of the multiplied phase. The processor 500 mixes the filtered resampled motor signal with the result of sine and cosine functions. The processor 500 applies an IIR low-pass filtering step to the obtained in-phase and quadrature signals. The processor 500 produces the demodulation result as the square root of the sum of square of IIR filter output.

At step S608, the processor 500 performs an envelope detection that determines the norm ∥*x*∥(*kT*) of the motor signal *x(kT).* In a preferred variant, the motor signal is the current flowing in one phase of the motor, the currents flowing in the other phase of the motor are also sensed at step S601, and the norm is determined as the square root of the sum of square of currents flowing in all the phase.

At step S609, the processor 500 determines a fault harmonic model from the norm ∥*x*∥(*kT*) and the fundamental frequency fs(kT). The processor 500 determines a proportionality ratio R(kT) between fault harmonic level and the level of fault in the motor. In a first implementation of invention, R(kT) = A* fs(kT)^B*∥*x*∥(kT)^C, where A, B and C are constant values. In a second implementation of invention, R(kT) = A (1+B*fs(kT)), where A, B are constant values.

At step S610, the processor 500 performs an angular resampling of the proportionality ratio R(kT) in order to obtain proportionality samples *R(nθΔ)* with regular angular sampling.

At step S611, the processor 500 performs a filtering of the samples *R(nθΔ).* The filtering is a notch filtering as disclosed in reference to Fig. 1. The filtering is identical to the filtering performed at step S606.

At step S612, the processor 500 performs a filtering of the samples provided by the filtering step S610. The filtering is a low pass filtering identical to the filtering performed at step S607.

At step S612, the processor 500 determines an estimated level of motor fault by comparing the demodulated signal obtained at step S607 and a signal derived from the signal provided by the motor from the output of the filtering step S612 as disclosed in reference to Fig. 1.

Then, processor 500 moves back to step S601.

In a variant, the level of motor fault estimated at step S612 is averaged over consecutive signal steps.

In a variant, steps S608 to S613 are only performed when the fundamental frequency identified at step S602 exceeds a predetermined level. As example, the predetermined level equals the maximum rotation speed of the motor divided by 2.

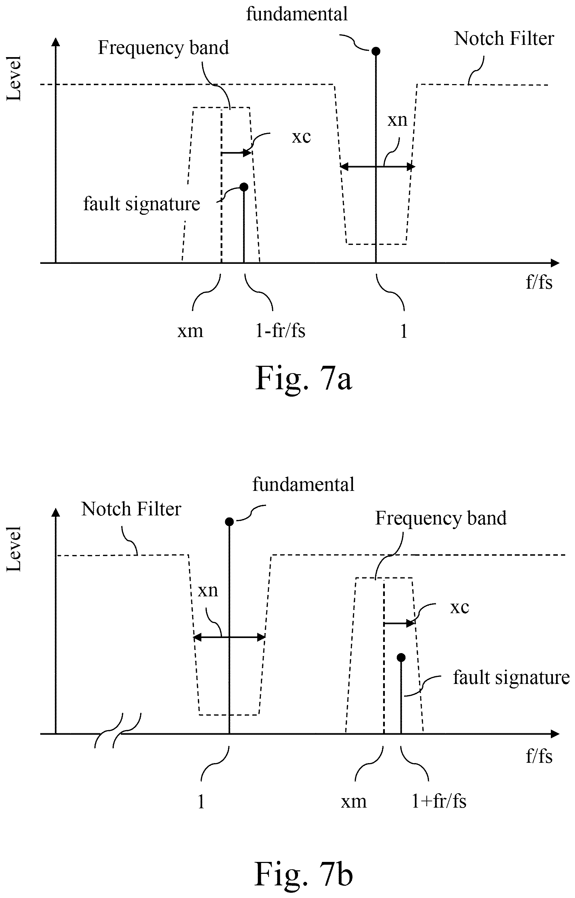

**Fig. 7a** represents a first example of spectral treatment of motor signal in presence of motor fault according to the invention.

The abscissa axis (f/fs) represents the signal frequencies, normalised to the fundamental frequency, while the ordinate axis (level) represents the level of signal frequency components. The motor signal contains a heavy fundamental component at abscissa 1 and a smaller fault signature signal located at abscissa 1-fr/fs.

This figure also represents the frequency response of Notch filter, centered around the strong fundamental component and with a normalised suppression band xn = fn/fs. The Notch filter aims at suppressing all frequency components located with the suppression band. The filter band determines the reaction time of the notch filter. Away from the notch band, the notch filter has unity frequency response and leaves the other frequency components of the signal untouched. The coefficient xn is chosen so that the fault signature frequency is preserved in the untouched area.

This figure also represents the position of the normalised central frequency xm, together with the frequency band on which incoherent heterodyne demodulation is applied according to invention. The frequency band contains frequencies comprised between (xm-xc)*fs and (xm+xc)*fs.

According to invention, incoherent heterodyne demodulation outputs the level of fault signature frequency component as long as the frequency of the fault signature belongs to the frequency band.

The implementation of a notch filter supresses interference due to the strong adjacent fundamental component present in vicinity of the frequency band that would otherwise be experienced, in spite of low-pass filter with normalised cut-off frequency xc. In this first example, the fault signature is representative of an eccentricity fault, The coefficients (xn,xm,xc) are chosen to detect the lower sideband harmonic resulting from an eccentricity fault. The machine has 2 pole pairs, a positive torque is applied by the load, and the fault signature signal has a frequency 1-fs/fr located at the right of the central frequency xm=1/2.

**Fig. 7b** represents a second example of spectral treatment of motor signal in presence of motor fault according to the invention.

In this second example, the fault signature is representative of an eccentricity fault. The coefficients (xn,xm,xc) are chosen to detect the upper sideband harmonic resulting from an eccentricity fault. The machine has 2 pole pairs, a negative torque is applied by the load, and the fault signature signal has a frequency 1+fs/fr located at the right of the central frequency xm=3/2.

## Claims

1. A method for detecting a motor fault during transient operation of the motor wherein the method comprises the steps of:
- sensing (S601)a motor signal,
- identifying (S602) a fundamental frequency of the motor signal, the fundamental frequency being the frequency of the voltage waveforms driving the stator of the motor,
**characterized by**
- performing a(S607) heterodyne incoherent demodulation of the motor signal on a frequency band, the central frequency of the frequency band and the bandwidth of the frequency band having fixed proportionality ratios with the identified fundamental frequency,
- determining (S613) the level of fault in the motor by comparing the demodulated signal and a signal derived from the motor signal.

2. The method according to claim 1, **characterized in that** the incoherent demodulation comprises the steps of:
- mixing the motor signal with a sine and a cosine waveforms oscillating at the central frequency,
- low-pass filtering the mixed signals with a cutoff frequency equal to the bandwidth of the frequency band,
- combining the low-pass filtered signals.

3. The method according to claim 2, **characterized in that** the method further comprises the step executed prior to the incoherent demodulation of:
- notch filtering the motor signal, the central frequency of the notch filter being equal to the identified fundamental frequency, the width of the notch having fixed proportionality ratio with the fundamental frequency, the central frequency of the frequency band being outside of the notch filter band.

4. The method according to claims 1 to 3, **characterized in that** proportionality ratios of the central frequency of the frequency band, the bandwidth of the frequency band, and the central frequency of the notch filter with the fundamental frequency are predetermined for a given fault type.

5. The method according to any of the claims 1 to 3, **characterized in that** the method further comprises the step executed prior to the heterodyne incoherent demodulation and/or the notch filtering of:
- angular resampling the motor signal, the resampled signal having equal-phase increment of signal rotating at the identified fundamental frequency.

6. The method according to claim 5, **characterized in that** the notch filtering and the low-pass filtering are implemented as IIR filters with fixed predetermined coefficients.

7. The method according to any of the claims 5 to 6, **characterized in that** the signal derived from the motor signal is obtained by :
- performing an envelope detection on the sensed motor signal,
- determining a proportionality ratio between fault harmonic level and a level of fault in the motor from the envelope and the fundamental frequency,
- performing an angular resampling of the proportionality ratio,
- notch filtering the resampled proportionality ratio,
- low pass filtering the notch filtered resampled proportionality ratio.

8. A device for detecting a motor fault during transient operation of the motor, wherein the device comprises:
- means for sensing at least one motor signal,
- means for identifying a fundamental frequency of a motor signal, the fundamental frequency being the frequency of the voltage waveforms driving the stator of the motor,
**characterized in that** the device comprises:
- means for performing a heterodyne incoherent demodulation of the motor signal on a frequency band, the central frequency of the frequency band and the bandwidth of the frequency band having fixed proportionality ratios with the identified fundamental frequency,
- means for determining the level of fault in the motor by comparing the demodulated signal and a signal derived from the motor signal

## Patentansprüche

1. Verfahren zum Erfassen eines Motorfehlers während eines transienten Betriebs des Motors,
wobei das Verfahren die Schritte umfasst zum:
- Abtasten (S601) eines Motorsignals,
- Identifizieren (S602) einer Grundfrequenz des Motorsignals, wobei die Grundfrequenz die Frequenz der Spannungswellenformen ist, die den Stator des Motors ansteuern,
**gekennzeichnet durch**
- Durchführen (S607) einer heterodynen inkohärenten Demodulation des Motorsignals auf einem Frequenzband, wobei die Mittenfrequenz des Frequenzbandes und die Bandbreite des Frequenzbandes feste Proportionalitätsverhältnisse mit der identifizierten Grundfrequenz aufweisen,
- Bestimmen (S613) des Fehlerpegels in dem Motor durch Vergleichen des demodulierten Signals und eines von dem Motorsignal abgeleiteten Signals.

2. Verfahren nach Anspruch 1, **dadurch gekennzeichnet, dass** die inkohärente Demodulation die Schritte umfasst zum:
- Mischen des Motorsignals mit einer Sinus- und einer Kosinus-Wellenform, die mit der Mittenfrequenz schwingt,
- Tiefpassfiltern der gemischten Signale mit einer Grenzfrequenz, die gleich der Bandbreite des Frequenzbandes ist,
- Kombinieren der tiefpassgefilterten Signale.

3. Verfahren nach Anspruch 2, **dadurch gekennzeichnet, dass** das Verfahren ferner den Schritt umfasst, der vor der inkohärenten Demodulation ausgeführt wird zum:
- Kerbfiltern des Motorsignals, wobei die Mittenfrequenz des Kerbfilters gleich der identifizierten Grundfrequenz ist, die Breite der Kerbe ein festes Proportionalitätsverhältnis zu der Grundfrequenz aufweist und die Mittenfrequenz des Frequenzbandes außerhalb des Kerbfilterbandes liegt.

4. Verfahren nach den Ansprüchen 1 bis 3, **dadurch gekennzeichnet, dass** die Proportionalitätsverhältnisse der Mittenfrequenz des Frequenzbandes, der Bandbreite des Frequenzbandes und der Mittenfrequenz des Kerbfilters zu der Grundfrequenz für einen gegebenen Fehlertyp vorbestimmt sind.

5. Verfahren nach einem der Ansprüche 1 bis 3, **dadurch gekennzeichnet, dass** das Verfahren ferner den Schritt umfasst, der vor der heterodynen inkohärenten Demodulation und/oder dem Kerbfiltern ausgeführt wird zum:
- Winkelneuabtasten des Motorsignals, wobei das neu abgetastete Signal einen gleichphasigen Inkrementwinkel des mit der identifizierten Grundfrequenz rotierenden Signals aufweist.

6. Verfahren nach Anspruch 5, **dadurch gekennzeichnet, dass** das Kerbfiltern und das Tiefpassfiltern als IIR-Filter mit festen vorbestimmten Koeffizienten implementiert wird.

7. Verfahren nach einem der Ansprüche 5 bis 6, **dadurch gekennzeichnet, dass** das von dem Motorsignal abgeleitete Signal gewonnen wird durch:
- Durchführen einer Hüllkurvenerfassung an dem abgetasteten Motorsignal,
- Bestimmen eines Proportionalitätsverhältnisses zwischen einem Pegel einer Fehlerharmonischen und einem Fehlerpegel in dem Motor aus der Hüllkurve und der Grundfrequenz,
- Durchführen einer Winkelneuabtastung des Proportionalitätsverhältnisses,
- Kerbfiltern des neu abgetasteten Proportionalitätsverhältnisses,
- Tiefpassfiltern des kerbgefilterten neu abgetasteten Proportionalitätsverhältnisses.

8. Vorrichtung zum Erfassen eines Motorfehlers während transienten Betriebs des Motors, wobei die Vorrichtung Folgendes umfasst:
- Mittel zum Abtasten mindestens eines Motorsignals,
- Mittel zum Identifizieren einer Grundfrequenz eines Motorsignals, wobei die Grundfrequenz die Frequenz der Spannungswellenformen ist, die den Stator des Motors ansteuern,
**dadurch gekennzeichnet, dass** die Vorrichtung Folgendes umfasst:
- Mittel zum Durchführen einer heterodynen inkohärenten Demodulation des Motorsignals auf einem Frequenzband, wobei die Mittenfrequenz des Frequenzbandes und die Bandbreite des Frequenzbandes feste Proportionalitätsverhältnisse mit der identifizierten Grundfrequenz aufweisen,
- Mittel zum Bestimmen des Fehlerpegels in dem Motor durch Vergleichen des demodulierten Signals und eines von dem Motorsignal abgeleiteten Signals.

## Revendications

1. Procédé de détection d'un défaut de moteur pendant un fonctionnement transitoire du moteur, le procédé comprenant les étapes consistant à :
- détecter (S601) un signal du moteur,
- identifier (S602) une fréquence fondamentale du signal du moteur, la fréquence fondamentale étant la fréquence des ondes de tension qui actionnent le stator du moteur,
**caractérisé par**
- effectuer (S607) une démodulation hétérodyne non cohérente du signal du moteur sur une bande de fréquences, la fréquence centrale de la bande de fréquences et la bande passante de la bande de bande de fréquences ayant des rapports de proportionnalité fixes par rapport à la fréquence fondamentale identifiée,
- déterminer (S613) le niveau de défaut dans le moteur en comparant le signal démodulé et le signal dérivé du signal du moteur.

2. Procédé selon la revendication 1, **caractérisé en ce que** la démodulation non cohérente comprend les étapes consistant à :
- mixer le signal du moteur avec une onde sinusoïdale et une onde cosinusoïdale oscillant à la fréquence centrale,
- filtrer passe bas les signaux mixés avec une fréquence de coupure égale à la bande passante de la bande de fréquences,
- combiner les signaux filtrés passe bas.

3. Procédé selon la revendication 2, **caractérisé en ce que** le procédé comprend en outre les étapes exécutées avant la démodulation non cohérente consistant à :
- filtrer coupe-bande le signal du moteur, la fréquence centrale du filtre coupe-bande étant égale à la fréquence fondamentale identifiée, la largeur de la bande d'arrêt ayant un rapport de proportionnalité fixe par rapport à la fréquence fondamentale, la fréquence centrale de la bande de fréquences étant hors de la gamme du filtre coupe-bande.

4. Procédé selon les revendications 1 à 3, **caractérisé en ce que** les rapports de proportionnalité de la fréquence centrale de la bande de fréquences, de la bande passante de la bande de fréquences et de la fréquence centrale du filtre coupe-bande par rapport à la fréquence fondamentale sont prédéterminés pour un type de défaut donné.

5. Procédé selon l'une quelconque des revendications 1 à 3, **caractérisé en ce que** le procédé comprend en outre l'étape exécutée avant la démodulation hétérodyne non cohérente et/ou le filtrage coupe-bande consistant à :
- effectuer un rééchantillonnage angulaire du signal du moteur, le signal rééchantillonné ayant un incrément de phase constant de signal tournant à la fréquence fondamentale identifiée.

6. Procédé selon la revendication 5, **caractérisé en ce que** le filtrage coupe-bande et le filtrage passe bas sont mis en œuvre sous forme de filtres RII à coefficients fixes prédéterminés.

7. Procédé selon l'une quelconque des revendications 5 à 6, **caractérisé en ce que** le signal dérivé du signal du moteur est obtenu par :
- détection d'enveloppe sur le signal du moteur détecté,
- détermination d'un rapport de proportionnalité entre le niveau de défaut harmonique et un niveau de défaut dans le moteur à partir de l'enveloppe et de la fréquence fondamentale,
- rééchantillonage angulaire du rapport de proportionnalité,
- filtrage coupe-bande du rapport de proportionnalité rééchantillonné,
- filtrage passe bas du rapport de proportionnalité rééchantillonné filtré coupe-bande,

8. Dispositif de détection d'un défaut de moteur pendant un fonctionnement transitoire du moteur, le dispositif comprenant :
- un moyen de détecter au moins un signal du moteur,
- un moyen d'identifier une fréquence fondamentale du signal du moteur, la fréquence fondamentale étant la fréquence des ondes de tension qui actionnent le stator du moteur,
**caractérisé en ce que** le dispositif comprend :
- un moyen d'effectuer une démodulation hétérodyne non cohérente du signal du moteur sur une bande de fréquences, la fréquence centrale de la bande de fréquences et la bande passante de la bande de bande de fréquences ayant des rapports de proportionnalité fixes par rapport à la fréquence fondamentale identifiée,
- un moyen de déterminer le niveau de défaut dans le moteur en comparant le signal démodulé et le signal dérivé du signal du moteur.
